# EUROPEAN PATENT APPLICATION

(11) **EP 1 648 025 A1**
(43) Date of publication of application: **19.04.2006**
(21) Application number: 05022159.7
(22) Date of filing: 11.10.2005
(51) Int. Cl.: H01L 21/677

(54) **Storage container**

(30) Priority: 14.10.2004 JP 2004300587
(71) Applicant: Miraial Co., Ltd., Tokyo (JP)
(72) Inventor: Matsutori, Chiaki, Kikuchi-shi Kumamoto-ken (JP); Obayashi, Tadahiro, Kikuchi-shi Kumamoto-ken (JP)
(74) Representative: Grünecker, Kinkeldey, Stockmair & Schwanhäusser Anwaltssozietät

(57) **Abstract**

To prevent a sealing member from falling off, facilitate attachment of the sealing member, and improve the sealing property of the sealing member. The sealing member of the present invention includes a plurality of individually deformable portions fitted into fitting groove portions separated across a protrusion in the fitting groove formed in one of a container main body and a cover member, a coupling portion connecting the individually deformable portions, and a sealing piece abutting against a wall surface of the other one of the container main body and the cover member to seal a space, the sealing piece being integrated with the coupling portion connecting the individually deformable portions. Convex ribs are respectively formed on opposite sides of the individually deformable portions to elastically come into close contact with the wall surface of the protrusion.

## Description

### BACKGROUND OF THE INVENTION

### 1. Field of the Invention

The present invention relates to a storage container for storing, conveying, and processing an electronic part-mounted board that should be kept clean during storage, such as a semiconductor wafer, a storage disk substrate, or a liquid crystal glass substrate.

### 2. Description of the Related Art

A variety of devices have been hitherto made on a storage container for storing an electronic part-mounted board such as a semiconductor wafer, a storage disk substrate, or a liquid crystal glass substrate under a clean atmosphere since if any foreign matter or contaminant adheres to such a board in the process of storing, conveying, and processing the board, a thin film or element formed on the surface thereof may be damaged, or element characteristics may be deteriorated.

In particular, sealing means for hermetically sealing a space between a storage container main body and a cover member is the key to preventing any foreign matter or contaminant from entering the storage container from the outside.

To that end, there is known, for example, an airtight container having a sealing member composed of an elastically deformable endless portion fitted into a fit-retention groove, a bendable projection, the leading edge of which extends almost obliquely from the peripheral corner of the endless portion, and a fitting rib recessed in or protruding from at least one of the front and rear sides of the endless portion (see Japanese Patent Laid-Open Publication No. 2002-68364).

However, the airtight container disclosed in Japanese Patent Laid-Open Publication No. 2002-68364 is structured such that the fit-retention groove and the endless portion of the sealing member are fitted only by means of the fitting rib recessed in or protruding from at least one of the front and rear sides of the endless portion, so that the fit between the sealing member and the fit-retention groove only depends on the elasticity of the elastic material forming the endless portion and the fitting dimensional accuracy between the endless portion and the fit-retention groove.

Hence, the above airtight container is insufficient in terms of the engagement between the endless portion of the sealing member and the fit-retention groove, leading to a problem that the sealing member easily falls off the fit-retention groove. In this case, when the elasticity of the elastic member forming the endless portion of the sealing member is made too high with a view to enhancing the engagement between the sealing member and the fit-retention groove, there arises a problem that the endless portion is hard to remove from the fit-retention groove.

### SUMMARY OF THE INVENTION

The present invention has been developed in view of the above problems, and accordingly, it is an object of the present invention to provide a storage container whose sealing member is not liable to fall off, and the sealing property of the sealing member is improved.

A storage container according to the present invention includes: a container main body which forms a housing portion having an opening; a cover member for closing the opening of the container main body; and a sealing member for hermetically sealing a space between the container main body and the cover member and formed on one of the container main body and the cover member, wherein the sealing member is fitted into a fitting groove formed in one of the container main body and the cover member, and includes a plurality of individually deformable portions disposed opposite to each other through a gap formed along a fitting direction in a sectional view, and a sealing piece for sealing a space in abutment with a wall surface of the other one of the container main body and the cover member.

In the storage container according to the present invention, preferably, the sealing member is fitted in such a manner that leading edges of the plurality of individually deformable portions fit into a deep portion of the fitting groove. In this case, preferably, the fitting groove has a protrusion fitted in between the plurality of individually deformable portions of a fitting portion of the sealing member. Further, preferably, at least one rib is formed on opposite sides of the plurality of individually deformable portions of the sealing member, which comes in close contact with the protrusion to keep an inner space airtight, or at least one lip is formed on opposite sides of the plurality of individually deformable portions of the sealing member, which comes in close contact with the protrusion to keep an inner space airtight.

Further, in the storage container according to the present invention, preferably, the plurality of individually deformable portions of the sealing member are continuously formed, and the sealing member is fitted in such a state that leading edges of the plurality of individually deformable portions are directed to a side opposite to the deep portion of the fitting groove. In this case, preferably, a fitting member is fitted between the plurality of individually deformable portions of the sealing member. Further, preferably, at least one rib is formed on the side opposite to the opposite sides of the plurality of individually deformable portions of the sealing member, which comes in close contact with a wall surface of the fitting groove to keep an inner space airtight, or at least one lip is formed on the side opposite to the opposite sides of the plurality of individually deformable portions of the sealing member, which comes in close contact with a wall surface of the fitting groove to keep an inner space airtight.

Further, preferably, in the storage container according to the present invention, slippage-preventing means for preventing the sealing member from coming off is provided on an opening side of the fitting groove. In addition, preferably, the fitting groove is expanded so as to incline at 1 to 6 degrees toward the opening. Further, preferably, the wall surface against which the sealing piece of the sealing member abuts is inclined within a bendable range of the leading edge of the sealing piece, and the wall surface against which the sealing piece of the sealing member abuts is one of a horizontal support and a vertical support that is inclined toward the sealing piece at an angle of 2 to 8 degrees to one of the horizontal plane and the vertical plane.

Furthermore, preferably, the plurality of individually deformable portions of the sealing member are inserted into the fitting groove in an elastically compressed state. Moreover, preferably, a gap of a predetermined capacity is secured between the plurality of individually deformable portions of the sealing member and a wall surface of the fitting groove.

Further, the container main body may include a thin-plate supporting portion supporting a plurality of thin plates disposed at a predetermined interval, and the cover member may include a thin-plate retainer supporting the plurality of thin plates supported by the thin-plate supporting portion under pressure.

The storage container according to the present invention includes a sealing member formed on one of a container main body and a cover member to hermetically seal a space therebetween, which is fitted into a fitting groove formed in one of the container main body and the cover member and includes a plurality of individually deformable portions disposed opposite to each other across a gap secured along the fitting direction in a sectional view, and a sealing piece abutting a wall surface of the other one of the container main body and the cover member, whereby the sealing member is not liable to come off and the sealing property of the sealing member is enhanced.

### BRIEF DESCRIPTION OF THE DRAWINGS

Fig. 1 is a schematic sectional view illustrative of an overall storage container according to a first embodiment of the present invention;
Fig. 2 is a schematic enlarged sectional view of a sealing member of the storage container;
Figs. 3A and 3B are schematic sectional views of the sealing member of the storage container;
Fig. 4 is a schematic enlarged sectional view illustrative of a sealing member according to a second embodiment of the present invention;
Figs. 5A and 5B are schematic sectional views of the sealing member of the storage container;
Fig. 6 is a schematic enlarged sectional view of a sealing member of a storage container illustrative of a third embodiment of the present invention;
Figs. 7A and 7B are schematic enlarged sectional views illustrative of a sealing member of a storage container according to a fourth embodiment of the present invention;
Fig. 8 is a schematic sectional view illustrative of a sealing member of a storage container according to a fifth embodiment of the present invention; and
Fig. 9 is an enlarged sectional view illustrating the sealing member.

### DESCRIPTION OF THE PREFERRED EMBODIMENTS

Hereinafter, embodiments of a storage container of the present invention will be described with reference to the accompanying drawings.

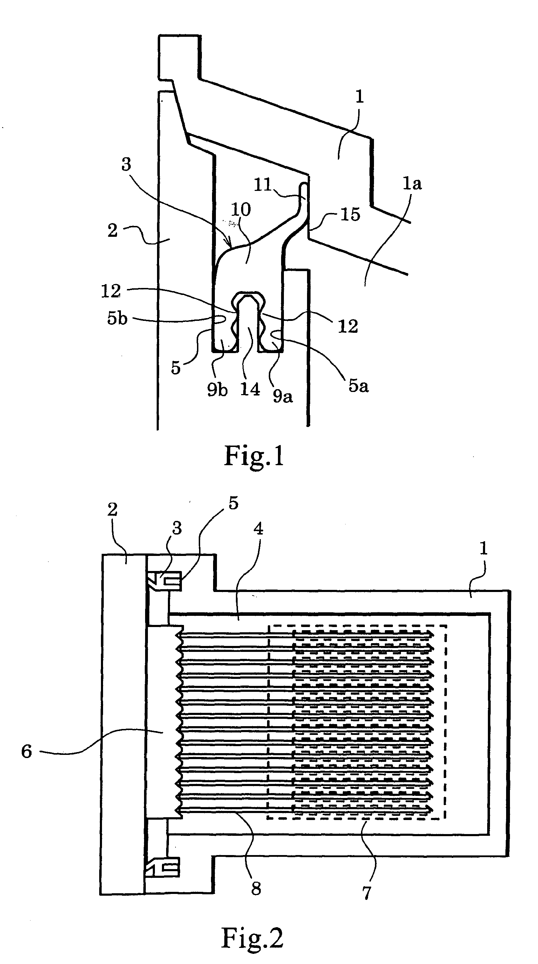

Referring to Fig. 2, a first embodiment of the storage container of the present invention will be described. Fig. 2 is a sectional view schematically showing the storage container.

The storage container includes a container main body 1 forming a housing portion (i.e., inner space) 4 having an opening 1a, a cover member 2 for covering the opening 1a of the container main body 1, and a sealing member 3 for keeping the inner space 4 of the container main body 1 airtight with the opening 1a of the container main body 1 being closed with the cover member 2.

Further, a thin-plate retainer 6 is attached to the inner side of the cover member 2. A thin-plate supporting portion 7 is attached to an inner side face of the container main body 1. The thin-plate retainer 6 and the thin-plate supporting portion 7 are grooved at regular intervals. Thus, when the cover member 2 is put on the container main body while thin plates 8 are held in these grooves, the thin plates 8 can be arrayed in position at predetermined intervals almost in parallel by means of the thin-plate retainer 6 and the thin-plate supporting portion 7.

The container main body 1 and the cover member 2 are preferably formed of a polymer material that generates little gas, for example, polycarbonate. Besides, the thin-plate retainer 6 and the thin-plate supporting portion 7 are preferably formed of a polymer material such as polyethylene or polybutelene terephthalate.

The sealing member 3 has a closed ring shape as viewed from the left side of Fig. 2. The sealing member 3 is interposed between the container main body 1 and the cover member 2 to thereby shut out the inflow of the outside air into the inner space 4 of the container main body 1. In the storage container 1, a fitting groove 5 is formed in a circular form along the outer periphery of the cover member 2, and one side of the sealing member 3 is fitted into the fitting groove 5, while the other side thereof is brought into contact with an inner wall surface 15 of the container main body 1. In this way, the space between the container main body 1 and the cover member 2 is sealed. Note that the fitting groove 5 is formed on the container main body 1 side in Fig. 2, but may be formed on the cover member 2 side. Fig. 1 shows an example where the fitting groove 5 is formed on the cover member 2 side.

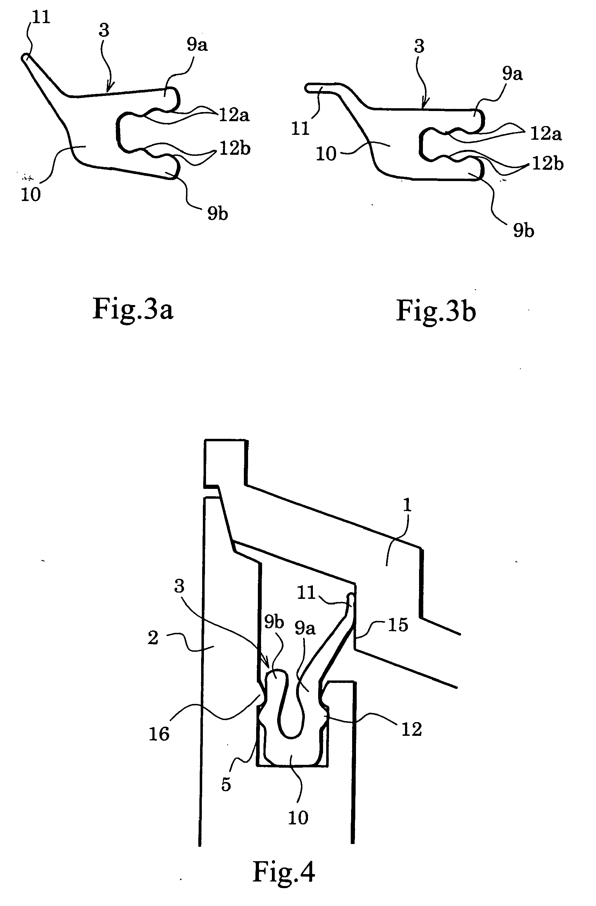

Referring next to Fig. 1, and Figs. 3A and 3B, the sealing member 3 is described in detail. Fig. 1 shows the example where the fitting groove 5 is formed on the cover member 2 side, which is a schematic enlarged sectional view of the sealing member of the cover member 2. Fig. 3A illustrates the sealing member 3 not fitted into the fitting groove 5. Fig. 3B illustrates the sealing member 3 fitted into the fitting groove 5 with the cover member 2 put on the container main body 1. The following description is focused on the sealing member 3 fitted into the fitting groove 5, so that there is no distinction made about whether the fitting groove 5 is formed on the cover member 2 side or the container main body 1 side.

The sealing member 3 is, as shown in Figs. 3A and 3B, fitted into the fitting groove 5 formed on either the container main body 1 side or the cover member 2 side, and composed of plural portions (hereinafter, referred to "individually deformable portions) 9a, 9b which are individually deformable, and disposed opposite to each other across a gap defined in the fitting direction as viewed in a sectional view, a coupling portion 10 connecting the individually deformable portions 9a and 9b, and a sealing piece 11 that abuts against the other wall surface of either the container main body 1 or the cover member 2 for sealing an inner space 4. The sealing piece 11 is integrated with the coupling portion 10 connecting the individually deformable portions 9a and 9b. The individually deformable portions 9a, 9b and the coupling portion 10 constitute a main body portion. The main body is fitted into the fitting groove 5 to support the sealing piece 11.

On the other hand, a protrusion 14 projects outwardly from the deep portion (i.e., bottom) of the fitting groove 5. The protrusion 14 is formed on the bottom of the fitting groove 5 throughout the perimeter thereof, and fitting groove portions 5a and 5b are formed between the side walls of the protrusion 14 and the fitting groove 5. That is, two stripes of sub-groves are formed.

In addition, the individually deformable portions 9a and 9b of the sealing member 3 have two convex ribs 12 each; the two ribs 12 are each formed on the opposite sides of the individually deformable portions 9a and 9b facing the protrusion 14, elastically in close contact with the side faces of the protrusion 14. The ribs 12 are formed along the perimeter of the side faces of the individually deformable portions 9a and 9b in a closed ring shape.

In this way, forming the ribs 12 in the individually deformable portions 9a, 9b in close contact with the side faces of the protrusion 14 makes it possible to more securely seal the gap and improve the sealing property of the sealing member. Herein, the example where the individually deformable portions 9a and 9b have the two ribs 12 each is discussed. However, one rib or three or more ribs may be formed on each portion. Besides, the ribs 12 may be formed on not only one side, but also on the other side of the individually deformable portions 9a, 9b, that is, the side opposite to the protrusion 14. Alternatively, the ribs 12 may be formed only on the other side.

By adopting such a structure that the protrusion 14 is formed inside the fitting groove 5 to form plural fitting groove portions (i.e., sub-groove portions), and the individually deformable portions 9a, 9b are fitted into the fitting groove portions, the fitting area can be increased to enhance the engagement and secure a long seal length. Thus, the sealing property of the sealing member can be enhanced. The formation of the ribs 12 in the individually deformable portions 9a, 9b, in close contact with the wall surfaces of the protrusion 14 makes it possible to more securely seal the gap and attain a much higher sealing property of the sealing member.

This beneficial effect is more marked in the case of increasing the number of protrusions 14 (i.e., sub-groove portions). However, a larger number of protrusions 14 (i.e., sub-groove portions) are difficult to mold and engage with the individually deformable portions 9a and 9b. In addition, a manufacturing cost increases. Thus, the number of protrusions 14 is appropriately set in consideration of such points.

Further, the leading edge of the sealing piece 11 of the sealing member 3 elastically bends to abut against the inner wall surface 15 as a close-contact portion of the container main body 1 to shut out the inflow of the outside air into the housing space 4 of the container main body 1. In this case, it is preferred that the sealing piece 11 be tilted with respect to the inner wall surface 15 (also referred to as "close-contact portion") of the container body 1 so as to secure sufficient adhesion when the leading edge of the sealing piece 11 comes into close contact with the wall surface 15. That is, the sealing piece 11 is preferably formed at an angle to the wall surface in a deformable range of the leading edge when in close contact therewith. This makes it possible to more securely seal the gap and improve the sealing property of the sealing member.

A material for the sealing member 3 is preferably an elastic polymer that generates little gas. For example, polyester elastomer or polyolefin elastomer may be used. Specific examples of polyester elastomer mainly include a copolymer mainly containing a terephthalic acid, 1,4-tetramethylene glycol, and polyoxyethylene glycol, or a polymer compound thereof.

As shown in Fig. 3A, the sealing member 3 thus structured is splayed in such a direction as to increase the distance between the individually deformable portions 9a and 9b before being fitted into the fitting groove 5. Also, the sealing piece 11 straightly extends without deforming.

As shown in Fig. 1 and Fig. 3B, in the sealing member 3, the individually deformable portions 9a and 9b are fitted into the fitting groove portions 5a and 5b between the wall surface of the fitting groove 5 and the wall surface of the protrusion 14 so that the leading edges of the individually deformable portions 9a and 9b fit into the deep portion (i.e., bottom) of the fitting groove 5, and the protrusion 14 is fitted in between the individually deformable portions 9a and 9b.

Thus, the individually deformable portions 9a and 9b of the sealing member 3 exert the elastic restoring force to the state of Fig. 3A, but at the same time, they are compressed between the fitting groove 5 and the protrusion 14 and thus come into close contact with the wall surfaces of the fitting groove 5. At this time, as shown in Fig. 1, almost no gap remains between the wall surface and the individually deformable portions 9a, 9b after the fitting, so these portions cannot undergo any further compressive deformation. As a result, the larger pressing force on the fitting groove 5 is attained due to not only the elastic force with which the individually deformable portions 9a, 9b are restored to their original state but also the elastic force of a material forming the sealing member 3.

Then, in this state, the cover member 1 is put on the container main body 1, thereby bringing the leading edge of the sealing piece 11 of the seal member 3 into close contact with the wall surface 15 of the container main body 1 to seal the gap between the sealing piece 11 of the sealing member 3 and the container main body 1. Therefore, the housing space 4 of the container main body 1 is kept airtight by blocking out the outside air.

In this way, this storage container is provided with the sealing member 3 for hermetically sealing a space between the container main body 1 and the cover member 2 on either one thereof. The sealing member 3 includes the plurality of individually deformable portions, which are fitted into the fitting groove 5 formed on one of the container main body 1 and the cover member 2, and the sealing piece 11 for sealing the gap in abutment with the wall surface of the other one. This makes it possible to separate or disperse the elastic force at the fitted portion with the fitting groove 5, and facilitates the adjustment of the adhesion between the sealing member 3 and the fitting groove 5, and the attachment of the sealing member 3 while preventing the sealing member 3 from coming off, with the result that the sealing property of the sealing member is enhanced.

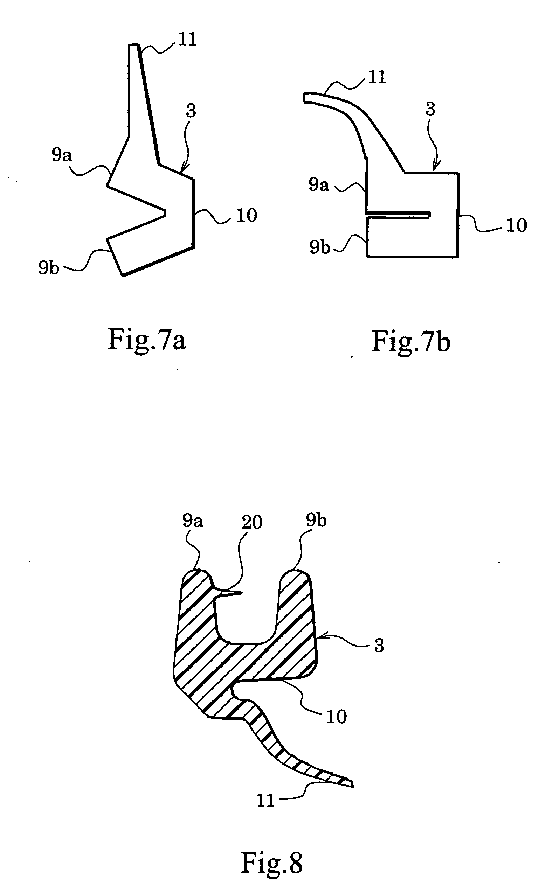

In this example, the protrusion 14 is formed with a large thickness to set a large interval between the individually deformable portions 9a and 9b in accordance therewith. However, as shown in Figs. 7A and 7B, the interval between the individually deformable portions 9a and 9b may be set smaller like a slit, and the protrusion 14 may be formed into a thin wall plate. In this case as well, the sealing property can be enhanced.

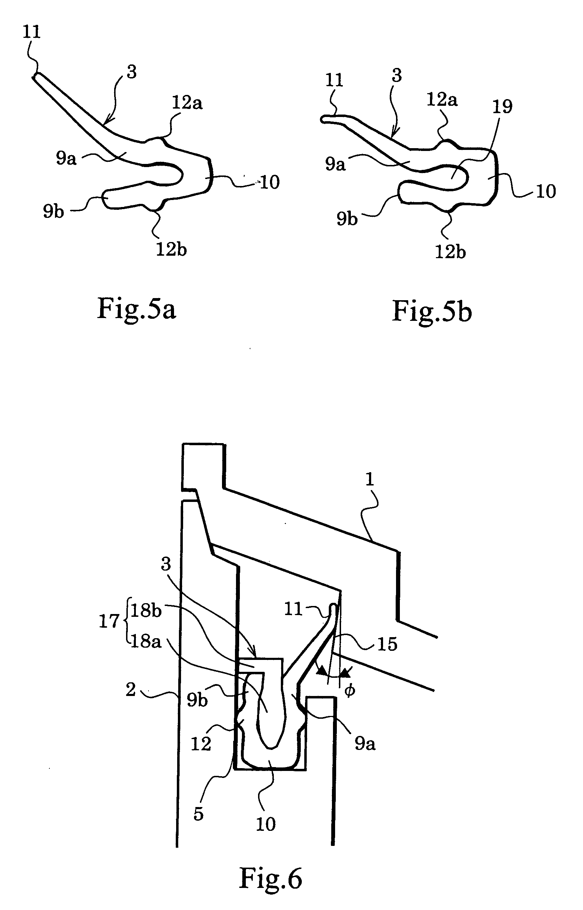

Referring next to Fig. 4 and Figs. 5A and 5B, a second embodiment of the present invention is described. Fig. 4 is a schematic enlarged sectional view of a sealing member portion of a storage container according to this embodiment. Fig. 5A illustrates the sealing member 3 not fitted into the fitting groove 5. Fig. 5B illustrates the sealing member 3 fitted into the fitting groove 5 with the cover member 2 put on the container main body 1.

Similar to the first embodiment, the sealing member 3 of this embodiment is composed of the individually deformable portions 9a, 9b fitted into the fitting groove 5 formed on one of the container main body 1 and the cover member 2, the coupling portion 10 connecting the individually deformable portions 9a and 9b and fitted into the fitting groove 5, and the sealing piece 11 for sealing the gap in abutment with the wall surface of the other one of the container main body 1 and the cover member 2. The sealing piece 11 is integrated with one of the individually deformable portions, the individually deformable portion 9a. Note that the position of the coupling portion 10 is the reverse of that of the first embodiment. Hence, the individually deformable portions 9a, 9b and the coupling portion 10 are formed in a U-shaped sectional view expanded outside.

The individually deformable portions 9a and 9b of the sealing member 3 not fitted into the fitting groove 5 are also expanded at some distance from each other as shown in Fig. 5A. Further, the ribs 12 are formed on the opposite sides of the individually deformable portions 9a, 9b in close contact with the wall surfaces of the fitting groove 5.

On the other hand, convex braces 16 are formed in abutment with the individually deformable portions 9a, 9b of the sealing member 3 near the opening of the wall surfaces of the fitting groove 5. The brace 16 prevents the individually deformable portions 9a, 9b of the sealing member 3 from coming off from the fitting groove 5 due to an external force or a difference between external pressure and internal pressure. Thus, the brace 16 does not need to be formed throughout the perimeter of the fitting groove 5, and thus only needs to be formed partially. Further, if the sealing member 3 has sufficient elastic restoring force, the brace 16 may be omitted.

As shown in Fig. 4 and Fig. 5B, the sealing member 3 thus structured is fitted into the fitting groove 5 such that the coupling portion 10 connecting the individually deformable portions 9a and 9b fits into the deep portion of the fitting groove 5, that is, the leading edge of the individually deformable portions 9a, 9b are directed to the side opposite to the deep portion of the fitting groove 5.

Thus, in a state where the sealing member 3 is fitted therein, a gap 19 is defined between the individually deformable portions 9a and 9b, and the ribs 12 and 12b are pressed against the wall surfaces of the fitting groove 5 mainly by means of the elastic restoring force with which the individually deformable portions 9a, 9b are restored to the original state, i.e., unfitted state.

Therefore, as compared with the sealing member of the first embodiment, the fitting force is weakened, but the degree of freedom of the individually deformable portions 9a and 9b is increased. Thus, the adhesion of the ribs 12 to the wall surfaces of the fitting groove 5 improves, resulting in the high sealing property of the sealing member. That is, the ribs 12 can exert the same function as lips 20 mentioned below. Further, the force of fitting the sealing member 3 into the fitting grooves 5 is small, and accordingly the wear of the fitting portion resulting from the friction due to the externally applied vibration can be suppressed. Thus, it is possible to minimize the generation of any foreign matter at the fitting portion even if a vibration is externally applied. The fitting force can be adjusted by selecting a suitable size of the gap 19, a suitable thickness of the individually deformable portions 9a, 9b, and a suitable material for the sealing member 3.

In this case, the brace 16 formed near the opening of the fitting groove 5 can engage with the ribs 12a and 12b, so that the sealing member 3 never comes off from the fitting groove 5 as long as the sealing member 3 is being used ordinally, despite the weak fitting force. On the other hand, in the fitted state, the gap 19 is formed, so that the gap is mechanically squashed, whereby the individually deformable portions 9a and 9b can be removed together with the coupling portion 10 from the fitting groove while avoiding the brace 16.

The storage container accommodating a semiconductor wafer for storage, conveyance, and processing under a clean atmosphere is repeatedly washed for the purposes of removing contaminants and preventing contamination. In this case, if the sealing member 3 can be easily removed, the washing step can be simplified, and the washing efficiency can be improved.

Referring next to Fig. 6, a third embodiment of the present invention is described. Fig. 6 is a schematic enlarged sectional view of a sealing member portion of a storage container according to this embodiment.

In this embodiment, a fitting member 17 is fitted in between the individually deformable portions 9a and 9b of the sealing member 3 of the second embodiment. The fitting member 17 includes a bulging portion 18a inserted between the individually deformable portions 9a and 9b, and a retainer 18b abutting against the end of one of the individually deformable portions 9a and 9b, which does not have the integrally formed sealing piece 11, that is, the individually deformable portion 9b. The bulging portion 18a and the retainer 18b are integrally formed.

The bulging portion 18a of the fitting member 17 is inserted between the individually deformable portions 9a and 9b, so the individually deformable portions 9a and 9b are pushed outward against the wall surface of the fitting groove 5. Accordingly, the adhesion between the individually deformable portions 9a, 9b and the fitting groove 5 improves. Note that the fitting member 17 may be formed into the closed ring shape. However, in order to facilitate the insertion between the individually deformable portions 9a and 9b of the sealing member 3, a string-like member is preferably used. Further, the retainer 18b of the fitting member 17 may be omitted. The ribs 12 are optionally provided.

On the other hand, in this embodiment, the wall surface (i.e., close-contact portion) 15 of the container main body 1 in close contact with the sealing piece 11 of the sealing member 3 is formed in an inclined state at the angle of θ in the direction in which the sealing piece 11 is tilted. That is, when the storage container is placed in a horizontal position during use, the opening 1a of the container main body 1 opens in a horizontal direction, and thus the wall surface 15 is set upright (i.e., vertical support). The wall surface 15 is inclined toward the sealing piece 11 at the angle φ to the vertical plane.

Accordingly, the sealing piece 11 of the sealing member 3 can stably come into close contact with the wall surface 15. An experiment carried out by the inventors of the present invention revealed that, provided the angle φ is within 2 to 8 degrees, the sealing piece 11 can stably come into close contact with the wall surface 15 as the vertical support even if the cover member 2 is repeatedly attached to/detached from the container main body 1. This is because when the inclination angle φ is set to 2° or more, the pressing force acts on the leading edge of the sealing piece 11 toward the circumferential direction, so that uniform stress can be attained at the leading edge of the sealing piece 11, thereby enabling the stable adhesion. If the inclination angle φ is 8° or more, the adhesion becomes unstable. This is supposedly because the pressing force with which the sealing piece 11 presses the wall surface 15 is lowered.

Note that if the storage container is used upright, the wall surface 15 extends in a horizontal direction (i.e., horizontal support), and is assumed to tilt toward the sealing piece 11 at the angle φ to the horizontal plane.

Referring next to Figs. 7A and 7B, a fourth embodiment of the present invention is described. Figs. 7A and 7B are schematic enlarged sectional views of a sealing member used in this embodiment, in which Fig. 7A illustrates the sealing member not fitted into a fitting groove and Fig. 7B illustrates the sealing member fitted into the fitting groove with the cover member put on the container main body.

The sealing member 3 of this embodiment also includes the individually deformable portions 9a and 9b fitted into the fitting groove 5 formed on one of the container main body 1 and the cover member 2, the coupling portion 10 connecting the individually deformable portions 9a and 9b and fitted into the fitting groove 5, and the sealing piece 11 sealing the gap in abutment with the other one of the container main body 1 and the cover member 2. The sealing piece 11 is integrally formed with one of the individually deformable portions 9a and 9b, the individually deformable portion 9a.

In the sealing member 3, when the sealing member is inserted into the fitting groove 5 with the coupling portion 10 fitting into the deep portion of the fitting groove 5, as shown in Fig. 7B, almost no gap is left between the individually deformable portions 9a, 9b; the individually deformable portions 9a and 9b no longer undergo compressive deformation.

Accordingly, if the sealing member 3 is inserted into the fitting groove 5 with the coupling portion 10 fitting into the deep portion of the fitting groove 5, the individually deformable portions 9a and 9b come into close contact with the wall surfaces of the fitting groove 5 due to the elastic restoring force that restores these portions to a splayed form as shown in Fig. 7A.

At this time, almost no gap remains between the individually deformable portions 9a and 9b, so that they cannot undergo any further compressive deformation. Hence, a large pressing force acts on the wall surface of the fitting groove 5 due to not only the elastic restoring force of the individually deformable portions 9a and 9b but also the elastic force of the material forming the sealing member 3.

Note that the ribs described in the above embodiments are omitted herein, but needless to say, the ribs may be formed.

Referring next to Fig. 8, a fifth embodiment of the present invention is described. Fig. 8 is a schematic enlarged sectional view showing a sealing member used in this embodiment, which has not been yet fitted into the fitting groove.

The sealing member 3 has the same structure as the sealing member 3 of the first embodiment except that one or more (in this example, one) lips 20 are formed on the opposite sides of the individually deformable portions 9a and 9b instead of the ribs 12. The lip 20 is an elastic deformable portion involving the flexion deformity. The lip 20 is inferior in terms of fitting force to the ribs, but is superior to the ribs in terms of adhesion and sealing property due to its large degree of freedom. Further, the wear of the sealing member resulting from externally applied vibration etc. can be suppressed because of its small fitting force.

The protrusion 14 is formed on one side inside the fitting groove 5. Thus, one of the fitting groove portions, i.e., the fitting groove portion 5b matches with one of the individually deformable portions, i.e., the individually deformable portion 9b. The sealing member 3 is held in the fitting groove 5 mainly by means of this portion and both side faces of the main body. Note that the lip 20 is provided only on the inner side of the individually deformable portion 9a, but may be optionally provided on the outer side thereof. Alternatively, the lip 20 may be provided only on the outer side of the individually deformable portion 9a, or on one or both of the sides thereof.

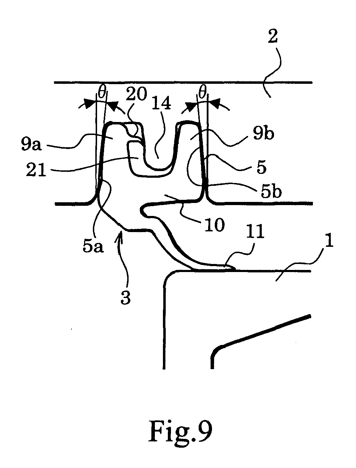

Fig. 9 is an enlarged view of a sealing member portion of a storage container using the above sealing member 3. Similar to the first embodiment, the sealing member is structured such that the individually deformable portions 9a and 9b of the sealing member 3 are fitted into the fitting groove portions 5a and 5b of the fitting groove 5 formed in the cover member 2.

At this time, the fitting groove portion 5a is formed in such a manner as to secure a gap 21 between the individually deformable portion 9a forming the lip 20 and the wall surface of the protrusion 14, whereby the lip 20 bends to come into close contact with the wall surface of the protrusion 14 due to the elastic deformity, thereby sealing the space. Also, the entire width of the individually deformable portions 9a and 9b is set somewhat larger than the width of the fitting groove 5, whereby the individually deformable portions 9a and 9b can come into close contact with the wall surfaces of the fitting groove 5.

At this time, the wall surfaces (i.e., outer and inner peripheral surfaces) of the fitting groove 5 are inclined inwardly at the angle of θ to the vertical plane. That is, the fitting groove 5 is so tilted as to expand toward the opening. The angle θ is preferably within a range of 1° to 6°, more preferably 3° to 5°. By tilting the surfaces within such an angular range, the individually deformable portions 9a and 9b of the sealing member 3 are easily inserted into the fitting groove 5, and sufficient fitting force can be maintained. Also, this enables the smooth removal from the mold upon molding, so that the satisfactory fitting surface can be obtained.

Note that the above embodiments describe the case where the fitting groove 5 is formed on the cover member 2 side by way of example, but similar effects can be obtained even when the fitting groove 5 is formed on the container main body 1 side.

## Claims

1. A storage container comprising:
a container main body forming a housing portion having an opening;
a cover member for closing the opening of the container main body; and
a sealing member for hermetically sealing a space between the container main body and the cover member and formed on one of the container main body and the cover member,
wherein the sealing member is fitted into a fitting groove formed in one of the container main body and the cover member, and includes a plurality of individually deformable portions disposed opposite to each other through a gap formed along a fitting direction in a sectional view, and a sealing piece for sealing a space in abutment with a wall surface of the other one of the container main body and the cover member.

2. The storage container according to Claim 1, wherein the sealing member is fitted in such a manner that leading edges of the plurality of individually deformable portions fit into a deep portion of the fitting groove.

3. The storage container according to Claim 2, wherein the fitting groove has a protrusion fitted in between the plurality of individually deformable portions of a fitting portion of the sealing member.

4. The storage container according to Claim 3, wherein at least one rib is formed on opposite sides of the plurality of individually deformable portions of the sealing member, which comes in close contact with the protrusion to keep an inner space airtight.

5. The storage container according to Claim 3, wherein at least one lip is formed on opposite sides of the plurality of individually deformable portions of the sealing member, which comes in close contact with the protrusion to keep an inner space airtight.

6. The storage container according to Claim 1, wherein the plurality of individually deformable portions of the sealing member are continuously formed, and the sealing member is fitted in such a state that leading edges of the plurality of individually deformable portions are directed to a side opposite to the deep portion of the fitting groove.

7. The storage container according to Claim 6, wherein a fitting member is fitted between the plurality of individually deformable portions of the sealing member.

8. The storage container according to Claim 6, wherein at least one rib is formed on the side opposite to the opposite sides of the plurality of individually deformable portions of the sealing member, which comes in close contact with a wall surface of the fitting groove to keep an inner space airtight.

9. The storage container according to Claim 6, wherein at least one lip is formed on the side opposite to the opposite sides of the plurality of individually deformable portions of the sealing member, which comes in close contact with a wall surface of the fitting groove to keep an inner space airtight.

10. The storage container according to Claim 1, wherein slippage-preventing means for preventing the sealing member from coming off is provided on an opening side of the fitting groove.

11. The storage container according to Claim 1, wherein the fitting groove is expanded so as to incline at 1 to 6 degrees toward the opening.

12. The storage container according to Claim 1, wherein the wall surface against which the sealing piece of the sealing member abuts is inclined within a bendable range of the leading edge of the sealing piece.

13. The storage container according to Claim 12, wherein the wall surface against which the sealing piece of the sealing member abuts is one of a horizontal support and a vertical support that is inclined toward the sealing piece at an angle of 2 to 8 degrees to one of a horizontal plane and a vertical plane.

14. The storage container according to Claim 1, wherein the plurality of individually deformable portions of the sealing member are inserted into the fitting groove in an elastically compressed state.

15. The storage container according to Claim 1, wherein a gap of a predetermined capacity is formed between the plurality of individually deformable portions of the sealing member and a wall surface of the fitting groove.

16. The storage container according to Claim 1, wherein the container main body includes a thin-plate supporting portion supporting a plurality of thin plates disposed at a predetermined interval, and the cover member includes a thin-plate retainer supporting the plurality of thin plates supported by the thin-plate supporting portion under pressure.

17. A storage container comprising:
a container main body which forms a housing portion having an opening;
a cover member for closing the opening of the container main body; and
a sealing member for hermetically sealing a space between the container main body and the cover member and formed on one of the container main body and the cover member,
wherein the sealing member has a main body portion fitted into a fitting groove formed in one of the container main body and the cover member, and a sealing piece extending from the main body portion to an opposite wall surface of the other one of the container main body and the cover member to seal a space between the container main body and the cover member in abutment with the wall surface,
the fitting groove has a plurality of sub-grooves at its bottom, and
the main body portion includes individually deformable portions respectively fitted into the plurality of sub-grooves.

18. The storage container according to Claim 17, wherein the individually deformable portions include a convex elastic rib formed throughout a perimeter on one side or both sides.

19. The storage container according to Claim 17, wherein the individually deformable portions are set smaller than an inner dimension of the sub-grooves, and include a lip having a larger degree of freedom than the individually deformable portions and formed throughout a perimeter on one side or both sides.

20. A storage container comprising:
a container main body which forms a housing portion having an opening;
a cover member for closing the opening of the container main body; and
a sealing member for hermetically sealing a space between the container main body and the cover member and formed on one of the container main body and the cover member,
wherein the sealing member has a main body portion fitted into a fitting groove formed in one of the container main body and the cover member, and a sealing piece extending from the main body portion to an opposite wall surface of the other one of the container main body and the cover member to seal a space between the container main body and the cover member in abutment with the wall surface,
the fitting groove has one or more sub-grooves throughout a perimeter at a bottom, and
the main body portion includes individually deformable portions sandwiching a wall plate.

21. A storage container comprising:
a container main body which forms a housing portion having an opening;
a cover member for closing the opening of the container main body; and
a sealing member for hermetically sealing a space between the container main body and the cover member and formed on one of the container main body and the cover member,
wherein the sealing member has a main body portion fitted into a fitting groove formed in one of the container main body and the cover member, and a sealing piece abutting against a wall surface opposite to the main body portion of the other one of the container main body and the cover member to seal a space between the container main body and the cover member, and
the main body portion is formed into a U-shaped sectional form expanded outside.

22. The storage container according to Claim 21, wherein the portion having the U-shaped sectional form is expanded beyond an inner dimension of the fitting groove.

23. The storage container according to Claim 21, further comprising a fitting member fitted into a deep portion of the portion having the U-shaped sectional form of the main body portion to bulge the main body portion so as to come into pressure contact with the fitting groove.

24. The storage container according to Claim 21, wherein the main body portion has a convex elastic rib formed throughout a perimeter on one side or both sides.

25. A storage container comprising:
a container main body which forms a housing portion having an opening;
a cover member for closing the opening of the container main body; and
a sealing member for hermetically sealing a space between the container main body and the cover member and formed on one of the container main body and the cover member,
wherein the sealing member has a main body portion fitted into a fitting groove formed in one of the container main body and the cover member, and a sealing piece abutting against a wall surface opposite to the main body portion of the other one of the container main body and the cover member to seal a space between the container main body and the cover member, and
the main body portion has a slit throughout a perimeter on an outer side to be expanded outward and formed such that the slit opens.
